# EUROPEAN PATENT APPLICATION

(11) **EP 1 111 830 A1**
(43) Date of publication of application: **27.06.2001**
(21) Application number: 00942381.5
(22) Date of filing: 29.06.2000
(51) Int. Cl.: H04J 13/04, H03L 7/14

(54) **METHOD AND APPARATUS FOR WIRELESS RECEPTION**

(30) Priority: 06.07.1999 JP 19146799
(71) Applicant: MATSUSHITA ELECTRIC INDUSTRIAL CO., LTD., Kadoma-shi, Osaka 571-8501 (JP)
(72) Inventor: TODA, Takashi, Ishikawa-gun, Ishikawa 921-8824 (JP); MINAMIDA, Noriaki, Kanazawa-shi, Ishikawa 920-0901 (JP); ARAMAKI, Yoshitaka, Yokosuka-shi, Kanagawa 239-0847 (JP)
(74) Representative: Grünecker, Kinkeldey, Stockmair & Schwanhäusser Anwaltssozietät
(86) International application number: JP0004271
(87) International publication number: WO0103348

(57) **Abstract**

Phase rotation speed detection section 108 detects a phase rotation speed of a known reference signal, measurement section 109 measures a parameter value indicative of the reception quality of the demodulated known reference signal, control voltage generation section 110 generates a VCO control voltage according to the phase rotation speed and the parameter value, VCO 111 changes the frequency of a carrier in proportion to a control voltage generated by control voltage generation section 110 and brings the frequency of the carrier closer to the carrier frequency of the received signal.

## Description

### Technical Field

The present invention relates to a radio reception apparatus and radio reception method used in CDMA-based radio communications.

### Background Art

In recent years, demands for terrestrial mobile communications such as car telephones and cellular telephones are drastically growing and the effective utilization of frequencies to secure the largest possible subscriber capacities on limited frequency bands is becoming more and more important.

A CDMA system is becoming a focus of attention as one of multiple access systems to effectively use frequencies . The CDMA system is a multiple access system using spread spectrum communication technologies, less susceptible to multi-path distortion, and characterized in that diversity effects can also be expected by combining multi-path components at a maximum ratio.

A radio reception apparatus used for this CDMA-based communication (hereinafter referred to as "CDMA radio reception apparatus") calculates a phase rotation speed per 1 symbol from the amount of phase rotation on a rectangular coordinate plane of a known reference signal in a received signal and performs auto frequency control (hereinafter referred to as "AFC") according to the phase rotation speed. Through this AFC, the CDMA radio reception apparatus corrects a difference between the carrier frequency of the received signal and demodulation carrier frequency generated by a voltage controlled oscillator (hereinafter referred to as "VCO").

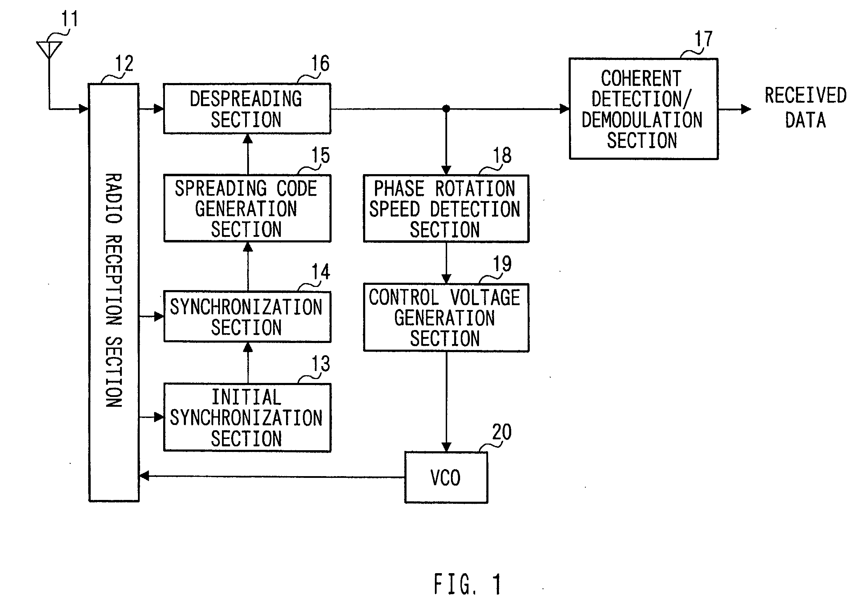

A conventional CDMA radio reception apparatus will be explained below using FIG.1. FIG.1 is a main block diagram showing an outlined configuration of the conventional CDMA radio reception apparatus. In the following explanations, it will be assumed that the transmitting side is a base station and the receiving side is a mobile station.

In FIG.1, radio reception section 12 amplifies a radio signal including a known reference signal received through antenna 11, multiplies the amplified received signal by a carrier and thereby extracts a baseband signal from the received signal. In the explanation below, the processing of extracting a baseband signal from the received signal will be called "quasi-coherent detection processing".

Initial synchronization section 13 identifies (cell search) a spreading code sent by the base station. Synchronization section 14 creates delay profile information according to the type of the spreading code and the timing of the spreading code identified by initial synchronization section 13. Spreading code generation section 15 generates a spreading code according to the spreading code and phase specified by synchronization section 14.

Despreading section 16 performs despreading processing by multiplying the baseband signal by a spreading code. Coherent detection/demodulation section 17 performs predetermined detection processing and predetermined demodulation processing on the despread signal to obtain received data.

Phase rotation speed detection section 18 calculates a phase angle, that is, the amount of phase rotation of the despread known reference signal on a rectangular coordinate plane and detects the amount of phase variation per 1 symbol, that is, the phase rotation speed of the known reference signal from the amount of phase rotation.

Control voltage generation section 19 controls VCO 20 according to the phase rotation speed. VCO 20 is an oscillator that generates a carrier used for quasi-coherent detection processing in radio reception section 12 and changes the frequency of the carrier under the control of control voltage generation section 19.

As shown above, the conventional CDMA radio reception apparatus detects the phase rotation speed using the received known reference signal and performs AFC by changing the VCO oscillation frequency according to this phase rotation speed. Thus, the conventional CDMA radio reception apparatus corrects a difference between the carrier frequency of the received signal and the carrier frequency generated by the VCO to reduce the amount of phase rotation generated on the baseband signal. In the explanations below, the difference between the carrier frequency of the received signal and the frequency of the carrier generated by the VCO will be called "carrier frequency error".

However, the conventional CDMA radio reception apparatus has the following problems. That is, in the conventional CDMA radio communication system, the base station transmits only a known reference signal, which is a pilot symbol, even if there is no data to be sent, and therefore the mobile station can perform AFC based on the phase of the known reference signal.

On the other hand, in order to reduce transmit power and reduce power of interference with other mobile station users, a system is recently proposed in which the base station also stops transmission of known reference signals when there is no data to be sent in services such as packet transmission.

When there is a period during which no known reference signal is sent from the base station, the conventional CDMA radio reception apparatus has a problem that AFC is carried out based on the phase of a noise signal for that period, that is, wrong AFC is carried out rather increasing the carrier frequency error.

Moreover, the conventional CDMA radio reception apparatus performs a cell search on signals sent from all base stations that the mobile station can receive when power to the mobile station is turned on. In that case, if the CDMA radio reception apparatus performs AFC using a known reference signal with a low reception level, an accurate phase rotation is not detected because the known reference signal with the low reception level has poor reception quality (S/N ratio, etc.), and therefore there is a problem that the carrier frequency error is rather increased.

The increased carrier frequency error results in an increase of the amount of phase rotation in the baseband signal, preventing the CDMA radio reception apparatus from performing correct demodulation processing.

### Disclosure of Invention

It is an object of the present invention to provide a CDMA radio reception apparatus and CDMA radio reception method capable of preventing a carrier frequency error from increasing for a period during which no known reference signal is sent from the other end of communication or during a cell search after power is turned on.

The inventors of the present invention have come up with the present invention by focusing attention on the fact that a carrier frequency error increases because the CDMA radio reception apparatus always controls over the VCO according to the phase rotation speed even for a period during which no known reference signal is sent from the other end of communication or when the reception level of the known reference signal is low, and discovering that in these cases, it is possible to prevent the carrier frequency error from increasing by the CDMA radio reception apparatus performing control over the VCO according to not only the phase rotation speed but also the reception condition of the known reference signal.

That is, in order to attain the above object, the present invention does not allow the VCO control voltage value to change when the reception quality of the known reference signal deteriorates and thereby maintains the frequency of the carrier generated by the VCO when the reception quality of the known reference signal is good.

### Brief Description of Drawings

FIG.1 is a main block diagram showing an outlined configuration of a conventional CDMA radio reception apparatus;

FIG.2 is a main block diagram showing an outlined configuration of a CDMA radio reception apparatus according to Embodiment 1 of the present invention;

FIG.3 is a main block diagram showing an outlined configuration of a control voltage generation section of the CDMA radio reception apparatus according to Embodiment 1 of the present invention;

FIG.4 is a main block diagram showing an outlined configuration of a CDMA radio reception apparatus according to Embodiment 2 of the present invention;

FIG.5 is a main block diagram showing an outlined configuration of a control voltage generation section of a CDMA radio reception apparatus according to Embodiment 3 of the present invention;

FIG.6 is a main block diagram showing an outlined configuration of a CDMA radio reception apparatus according to Embodiment 4 of the present invention; and

FIG.7 is a main block diagram showing another outlined configuration of a CDMA radio reception apparatus according to Embodiment 4 of the present invention.

### Best Mode for Carrying out the Invention

With reference now to the attached drawings, embodiments of the present invention will be explained in detail below.

### (Embodiment 1)

The CDMA radio reception apparatus according to Embodiment 1 of the present invention multiplies the amount of variation according to the phase rotation speed of the VCO control voltage value by a coefficient proportional or inversely proportional to each parameter value indicative of the reception quality of a known reference signal and reduces the variation of the VCO control voltage value as the reception quality deteriorates.

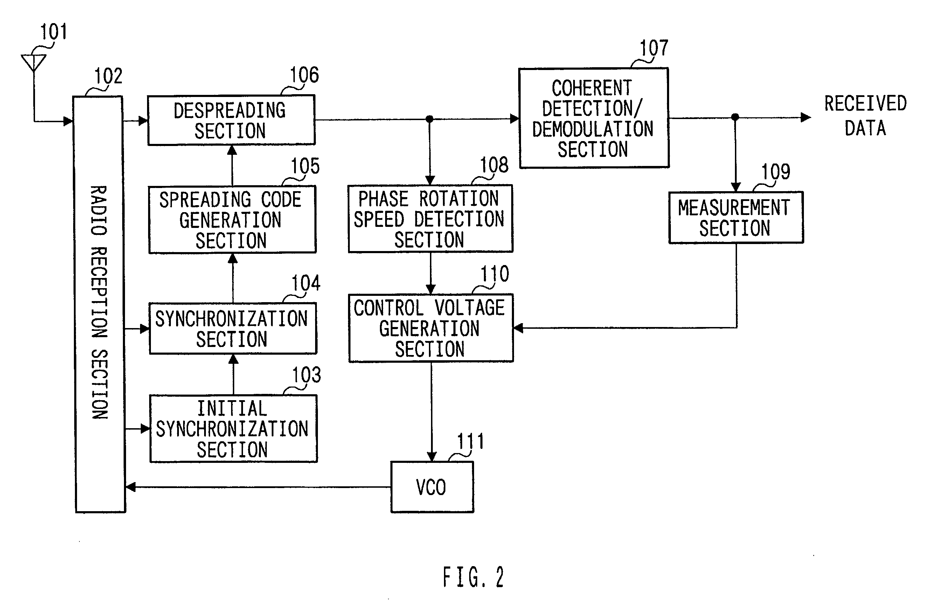

The CDMA radio reception apparatus according to Embodiment 1 of the present invention will be explained using FIG.2. FIG.2 is a main block diagram showing an outlined configuration of the CDMA radio reception apparatus according to Embodiment 1 of the present invention. In the explanation below, it will be assumed that the transmitting side is a base station and the receiving side is a mobile station.

In FIG.2, radio reception section 102 amplifies a radio signal including a known reference signal received through antenna 101, multiplies the amplified received signal by a carrier and thereby extracts a baseband signal from the received signal.

Initial synchronization section 103 identifies (cell search) a spreading code sent by the base station when power to the CDMA radio reception apparatus is turned on, etc. For example, in the case of a CDMA system asynchronous between base stations, initial synchronization section 103 identifies the type of the spreading code and the timing of the spreading code.

Synchronization section 104 creates delay profile information according to the type of the spreading code and the timing of the spreading code identified by initial synchronization section 103. Then, synchronization section 104 indicates the type of the spreading code and the timing of the spreading code to spreading code generation section 105 so that a signal of an optimal path corresponding to a maximum delay profile can be received.

Spreading code generation section 105 generates a spreading code according to the type of the spreading code and the timing of the spreading code indicated by synchronization section 104.

Despreading section 106 performs despreading processing by multiplying the baseband signal by the spreading code. Coherent detection/demodulation section 107 performs predetermined detection processing and predetermined demodulation processing on the despread signal to obtain received data.

Phase rotation speed detection section 108 calculates a phase angle of the known reference signal in the despread baseband signal on a rectangular coordinate plane, that is, the amount of phase rotation. Phase rotation speed detection section 108 then detects the amount of phase variation per 1 symbol, that is, the phase rotation speed of the known reference signal from the amount of phase rotation.

Measurement section 109 measures a parameter value indicative of the reception quality of the demodulated known reference signal. Examples of the parameter value measured by measurement section 109 include ① Received Signal Strength Indicator (hereinafter referred to as "RSSI"), which is reception power of a desired signal with respect to the known reference signal, ② Interference Signal Strength Indicator (hereinafter referred to as "ISSI"), which is reception power of an interference signal with respect to the known reference signal and ③ Signal to Interference Ratio (hereinafter referred to as "SIR"), which is the power ratio of a desired signal to an interference signal with respect to the known reference signal, etc.

When the reception quality of the known reference signal sent from the base station deteriorates or when there is a period during which no known reference signal is sent from the base station, ① the value of RSSI decreases, while ② the value of ISSI increases and ③ the value of SIR decreases.

Control voltage generation section 110 generates a VCO control voltage according to the phase rotation speed and the parameter value. When the phase rotation speed is negative, control voltage generation section 110 increases the control voltage in order to increase the frequency of the carrier generated by VCO 111 and when the phase rotation speed is positive, control voltage generation section 110 decreases the control voltage in order to decrease the frequency of the carrier generated by VCO 111.

This control is based on the fact that when the frequency of the carrier generated by VCO 111 is low with respect to the carrier frequency of the received signal, the phase rotation speed becomes negative and when the frequency of the carrier generated by VCO 111 is high with respect to the carrier frequency of the received signal, the phase rotation speed becomes positive.

VCO 111 is an oscillator that generates carriers used for quasi-coherent detection processing in radio reception section 102 and brings the frequency of the carrier closer to the carrier frequency of the received signal by changing the carrier frequency in proportion to the control voltage generated by control voltage generation section 110.

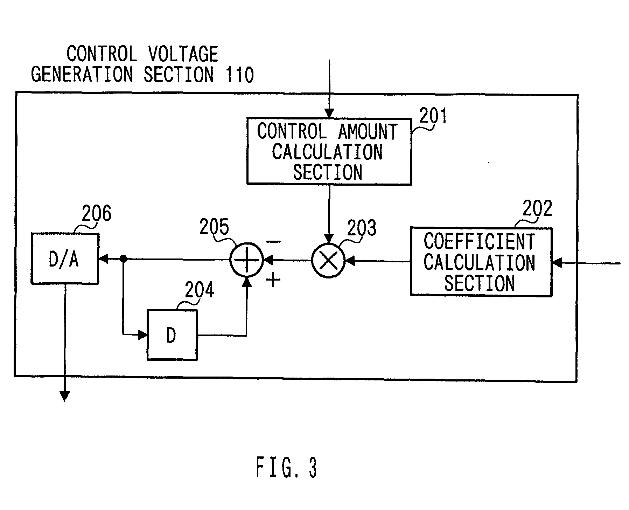

Then, the configuration of control voltage generation section 110 will be explained using FIG.3. FIG.3 is a main block diagram showing an outlined configuration of the control voltage generation section according to Embodiment 1 of the present invention.

In FIG.3, control amount calculation section 201 calculates the amount of variation of the control voltage value according to the polarity of phase rotation speed (positive or negative) and the absolute value of the phase rotation speed. When the phase rotation speed is negative, control amount calculation section 201 regards the amount of variation as a positive variation to increase the control voltage value and when the phase rotation speed is positive, control amount calculation section 201 regards the amount of variation as a negative variation to decrease the control voltage value. Moreover, control amount calculation section 201 increases the amount of variation of the control voltage value as the absolute value of the phase rotation speed increases.

Coefficient calculation section 202 calculates a coefficient that varies depending on each parameter value. This coefficient is a coefficient variable in a range of 0 to 1 and is ① proportional to the magnitude of RSSI when measurement section 109 measures RSSI, ② inversely proportional to the magnitude of ISSI when measurement section 109 measures ISSI and ③ proportional to the magnitude of SIR when measurement section 109 measures SIR. Moreover, a minimum value and a maximum value that each parameter will possibly take are measured by a simulation or field test, etc., beforehand and upper limit "1" and lower limit "0" of the coefficient are set so as to correspond to the minimum value and the maximum value. When the parameter value exceeding the range of the minimum value to the maximum value is measured, the coefficient is designated as upper limit "1" or lower limit "0", and therefore the coefficient always falls within the range of 0 to 1. That is, this coefficient takes a value closer to "0" as the reception quality of the demodulated known reference signal deteriorates and takes a value closer to "1" as the reception quality of the demodulated known reference signal improves.

Multiplier 203 multiplies the amount of variation of the control voltage value calculated by control amount calculation section 201 by the coefficient calculated by coefficient calculation section 202. This makes the amount of variation of the control voltage value calculated by control amount calculation section 201 reduce a great deal as the reception quality of the demodulated known reference signal deteriorates. Therefore, the amount of variation of the control voltage value that controls VCO 111 reduces as the reception quality of the demodulated known reference signal deteriorates.

Using a predetermined control power value as an initial value, delayer 204 retains the control voltage value output from adder 205 for a predetermined time to delay it by the predetermined time. Adder 205 adds up the control voltage value delayed by the predetermined time by delayer 204 and the amount of variation of the control voltage value to update the control voltage value. D/A converter 206 converts digital control voltage value data to an analog control voltage value signal.

Then, operation of the CDMA radio reception apparatus in the above configuration will be explained using FIG.2 and FIG.3. The received signal including a known reference signal received through antenna 101 is output to radio reception section 102. The received signal is amplified by radio reception section 102 and then multiplied by a carrier to extract a baseband signal. Then, the baseband signal is output to initial synchronization section 103, synchronization section 104 and despreading section 106.

Initial synchronization section 103 identifies (cell search) a spreading code sent from the base station when power to the CDMA radio reception apparatus is turned on, etc. Then, the identified type of the spreading code and timing of the spreading code are output to synchronization section 104.

Synchronization section 104 creates delay profile information according to the type of the spreading code and the timing of the spreading code output from initial synchronization section 103. Then, the type of the spreading code and the timing of the spreading code are output to spreading code generation section 105 so that a signal of an optimal path corresponding to a maximum delay profile can be received.

Spreading code generation section 105 generates spreading codes according to the type of the spreading code and timing of the spreading code indicated by synchronization section 104 and outputs the spreading code to despreading section 106.

Despreading section 106 performs despreading processing by multiplying the baseband signal by the spreading code. Then, the despread signal is output to coherent detection/demodulation section 107 and phase rotation speed detection section 108.

Coherent detection/demodulation section 107 performs predetermined detection processing and predetermined demodulation processing on the despread signal. The resultant received data is also output to measurement section 109.

Phase rotation speed detection section 108 calculates the amount of phase rotation of the known reference signal in the despread baseband signal. Phase rotation speed detection section 108 then detects the phase rotation speed of the known reference signal from the amount of phase rotation and outputs the phase rotation speed to control amount calculation section 201.

Control amount calculation section 201 calculates the amount of variation of the control voltage value according to the polarity of the phase rotation speed and the absolute value of the phase rotation speed and outputs these values to multiplier 203.

On the other hand, measurement section 109 measures a parameter value indicative of the reception quality of the demodulated known reference signal (① RSSI, ② ISSI, ③ SIR, etc.) and outputs the parameter value to coefficient calculation section 202.

Coefficient calculation section 202 calculates a coefficient that varies depending on each parameter value and outputs the coefficient to multiplier 203.

Multiplier 203 multiplies the amount of variation of the control voltage value calculated by control amount calculation section 201 by the coefficient calculated by coefficient calculation section 202 and outputs the amount of variation resulting from the multiplication to adder 205. In this way, the poorer the reception quality of the demodulated known reference signal, the greater the decrease in the amount of variation of the control voltage value calculated by control amount calculation section 201.

Adder 205 updates the control voltage value by adding up the control voltage value, which is delayed by a predetermined time by delayer 204 and then output, and the amount of variation of the control voltage value output from multiplier 203, which is reduced more as the reception quality deteriorates. Therefore, the poorer the reception quality of the demodulated known reference signal, the smaller the amount of variation of the control voltage value. The updated control voltage value is output to D/A converter 206.

D/A converter 206 converts digital control voltage value data to an analog control voltage value signal and outputs the analog control voltage value signal to VCO 111. VCO 111 generates a carrier whose frequency increases as the control voltage value increases and outputs the carrier to radio reception section 102. Radio reception section 102 multiplies the received signal by a carrier with a frequency that matches the carrier frequency of the received signal and extracts a baseband signal from the received signal.

Thus, the CDMA radio reception apparatus of this embodiment multiplies the amount of variation according to the phase rotation speed of a VCO control voltage value by a coefficient proportional or inversely proportional to each parameter indicative of the reception quality of a known reference signal and decreases the amount of variation of the VCO control voltage value as the reception quality deteriorates, and in this way can prevent a carrier frequency error from increasing when the reception quality of the known reference signal sent from the base station deteriorates or even when there is a period during which no known reference signal is sent from the base station.

### (Embodiment 2)

The CDMA radio reception apparatus according to Embodiment 2 of the present invention has a configuration almost identical to that of Embodiment 1, but differs from Embodiment 1 in that this embodiment determines the quadrant in which a known reference signal is located and reduces a variation of the VCO control voltage as the number of errors increases by multiplying the amount of variation according to the phase rotation speed of the VCO control voltage value by a coefficient inversely proportional to the number of errors of a known reference signal.

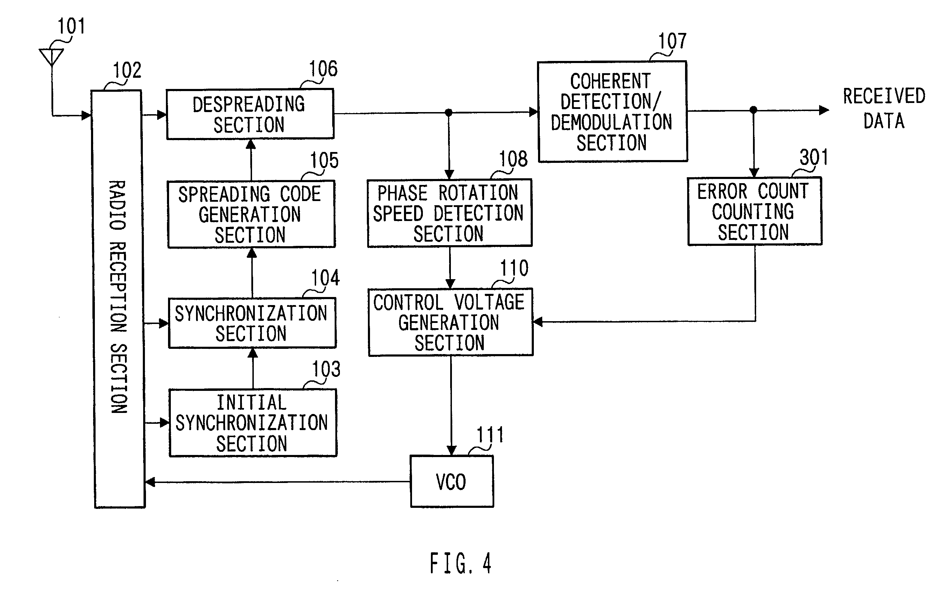

The CDMA radio reception apparatus according to Embodiment 2 of the present invention will be explained below using FIG.4. FIG.4 is a main block diagram showing an outlined configuration of the CDMA radio reception apparatus according to Embodiment 2 of the present invention. However, the same components as those in Embodiment 1 will be assigned the same reference numerals and detailed explanations thereof will be omitted.

In FIG.4, error count counting section 301 determines the quadrant in which a known reference signal is located. Since which quadrant the known reference signal should originally be located in is known beforehand, error count counting section 301 counts as an error count when the known reference signal is located in a quadrant other than the quadrant in which the known reference signal should originally be located.

Then, operation of the CDMA radio reception apparatus in the above configuration will be explained. In FIG.4, a known reference signal subjected to predetermined detection processing and predetermined demodulation processing by coherent detection/demodulation section 107 is output to error count counting section 301. Error count counting section 301 determines the quadrant in which the known reference signal is located. Error count counting section 301 then outputs the error count per a predetermined fixed time to coefficient calculation section 202 in control voltage generation section 110.

Coefficient calculation section 202 calculates a coefficient that varies in a range of 0 to 1 in inverse proportion to the error count and outputs the coefficient to multiplier 203. Upper limit "1" and lower limit "0" of this coefficient are preset so as to correspond to the maximum value and minimum value that the error count per the predetermined time could take. Therefore, the coefficient always falls within the range of 0 to 1. That is, this coefficient takes a value closer to "0" as the reception quality of the known reference signal deteriorates and takes a value closer to "1" as the reception quality of the known reference signal improves.

Thus, the CDMA radio reception apparatus of this embodiment determines the quadrant in which a known reference signal is located and decreases a variation of the VCO control voltage value as the error count increases by multiplying the amount of variation according to the phase rotation speed of a VCO control voltage value by a coefficient inversely proportional to the error count of the known reference signal, and in this way can prevent a carrier frequency error from increasing when the reception quality of the known reference signal sent from the base station deteriorates or even when there is a period during which no known reference signal is sent from the base station.

### (Embodiment 3)

The CDMA radio reception apparatus according to Embodiment 3 of the present invention has a configuration almost identical to that of Embodiment 1, but differs from Embodiment 1 in that this embodiment does not update the VCO control voltage value when each parameter value indicative of the reception quality of a known reference signal or the error count of the known reference signal falls below or exceeds a predetermined threshold.

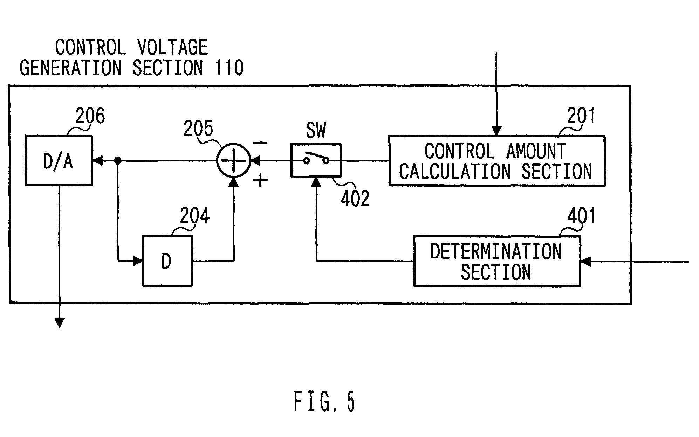

The CDMA radio reception apparatus according to Embodiment 3 of the present invention will be explained using FIG.5. FIG.5 is a main block diagram showing an outlined configuration of a control voltage generation section of the CDMA radio reception apparatus according to Embodiment 3 of the present invention. However, the same components as those in Embodiment 1 will be assigned the same reference numerals and detailed explanations thereof will be omitted.

In FIG.5, determination section 401 compares each parameter value or error count with a predetermined threshold preset in determination section 401. Determination section 401 then controls connection/disconnection of switch 402 based on this comparison result. Switch 402 connects or disconnects control amount calculation section 201 and adder 205 under the control of determination section 401.

Then, operation of the CDMA radio reception apparatus in the above configuration will be explained. Control amount calculation section 201 calculates the amount of variation of the control voltage value according to the polarity of the phase rotation speed and the absolute value of the phase rotation speed and outputs the amount of variation to switch 402.

Determination section 401 compares each parameter value or error count with a predetermined threshold preset in determination section 401. Determination section 401 then outputs a control signal for controlling connection/disconnection of switch 402 based on this comparison result.

More specifically, determination section 401 compares ① RSSI, ② ISSI, ③ SIR or ④ error count with these predetermined thresholds. Then, when ① RSSI is equal to or below a predetermined threshold, when ② ISSI exceeds a predetermined threshold, when ③ SIR is equal to or below a predetermined threshold or when ④ the error count exceeds a predetermined threshold, switch 402 is disconnected, and otherwise switch 402 is connected. That is, when the reception quality of the known reference signal is poor, switch 402 is disconnected and the VCO control voltage value is not updated.

Thus, the CDMA radio reception apparatus of this embodiment does not update the VCO control voltage value when each parameter value indicative of the reception quality of the known reference signal or the error count of the known reference signal falls below or exceeds a predetermined threshold, and therefore can prevent the carrier frequency error from increasing when the reception quality of the known reference signal sent from the base station deteriorates or even when there is a period during which no known reference signal is sent from the base station.

### (Embodiment 4)

The CDMA radio reception apparatus according to Embodiment 4 of the present invention has a configuration almost identical to that of Embodiment 1, but differs from Embodiment 1 in that this embodiment performs AFC during a cell search using a signal of a path with the highest reception level among those subjected to cell search so far.

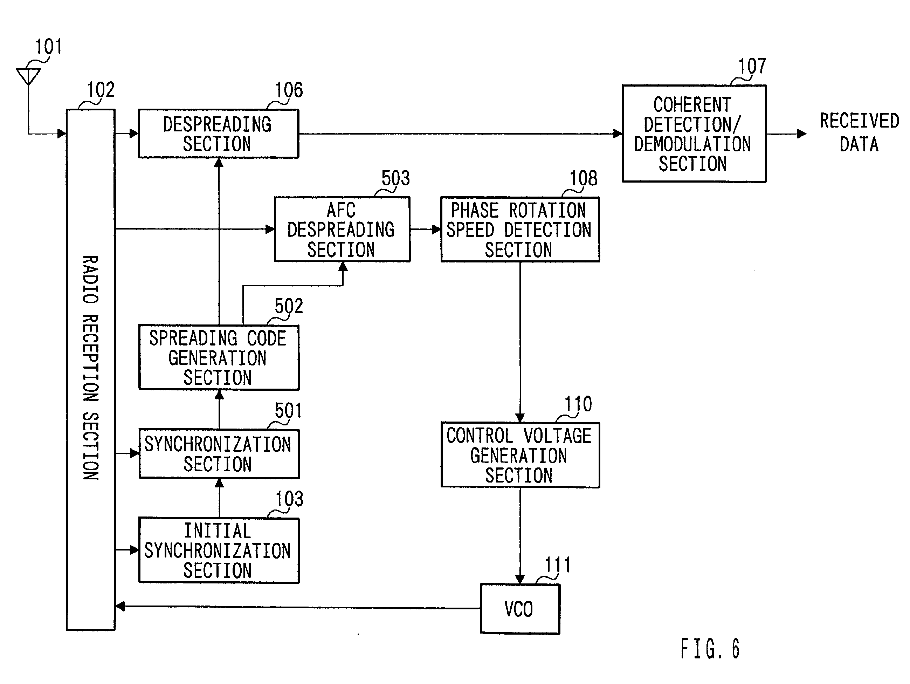

The CDMA radio reception apparatus according to Embodiment 4 of the present invention will be explained below using FIG.6. FIG.6 is a main block diagram showing an outlined configuration of the CDMA radio reception apparatus according to Embodiment 4 of the present invention. However, the same components as those in Embodiment 1 will be assigned the same reference numerals and detailed explanations thereof will be omitted.

Initial synchronization section 103 identifies (cell search) a spreading code sent from respective base stations that the CDMA radio reception apparatus can receive when power to the CDMA radio reception apparatus is turned on and creates delay profile information of the identified spreading code.

Synchronization section 501 has a table cumulatively retaining the spreading code identified by initial synchronization section 103 and the maximum value of reception power of the delay profiles of the spreading code. Synchronization section 501 instructs spreading code generation section 502 to generate a spreading code with the largest maximum value of reception power of the delay profile among the retained spreading codes for AFC despreading section 503 during cell search. Synchronization section 501 also sequentially instructs spreading code generation section 502 to generate spreading codes identified by initial synchronization section 103 for despreading section 106 during cell search.

Spreading code generation section 502 generates a spreading code with the largest maximum value of reception power of the delay profile for AFC despreading section 503 and sequentially generates spreading codes identified by initial synchronization section 103 for despreading section 106 according to the instruction from synchronization section 501.

AFC despreading section 503 is a dedicated despreading section used for AFC during a cell search and performs despreading processing by multiplying the baseband signal by the spreading code with the largest maximum value of reception power of the delay profile.

Then, operation of the CDMA radio reception apparatus in the above configuration will be explained.

Initial synchronization section 103 identifies (cell search) a spreading code sent from respective base stations that the CDMA radio reception apparatus can receive when power to the CDMA radio reception apparatus is turned on and creates delay profile information of the identified spreading code. The identified spreading code and delay profile information are output to synchronization section 501.

The identified spreading code and the maximum value of reception power of the delay profile of the spreading code are cumulatively retained in the table which synchronization section 501 has. Synchronization section 501 then outputs a signal to instruct spreading code generation section 502 to generate a spreading code with the largest maximum value of reception power of the delay profile among the spreading codes retained in the table for AFC despreading section 503 to spreading code generation section 502. Synchronization section 501 also sequentially outputs a signal to instruct spreading code generation section 502 to generate the spreading code identified by initial synchronization section 103 for despreading section 106 to spreading code generation section 502.

Spreading code generation section 502 outputs the spreading code with the largest maximum value of reception power of the delay profile to AFC despreading section 503 and sequentially outputs spreading codes identified by initial synchronization section 103 to despreading section 106 according to the instruction signal output from synchronization section 501.

AFC despreading section 503 performs despreading processing by multiplying the baseband signal by the spreading code with the largest maximum value of reception power of the delay profile. Then, the despread signal is output to phase rotation speed detection section 108.

Phase rotation speed detection section 108 calculates the amount of phase rotation of a known reference signal in the despread baseband signal. Then, phase rotation speed detection section 108 detects the phase rotation speed of the known reference signal and outputs the phase rotation speed to control voltage generation section 110.

In the configuration above, the signal with a spreading code providing the largest maximum value of reception power of the delay profile is used as the signal of the path with the highest reception level. However, the value indicative of the reception level is not limited to the delay profile information, but an SIR value, etc. of the received signal can also be used. In this case, initial synchronization section 103 not only identifies spreading codes but also measures the SIR value, etc. of the received signal during cell search.

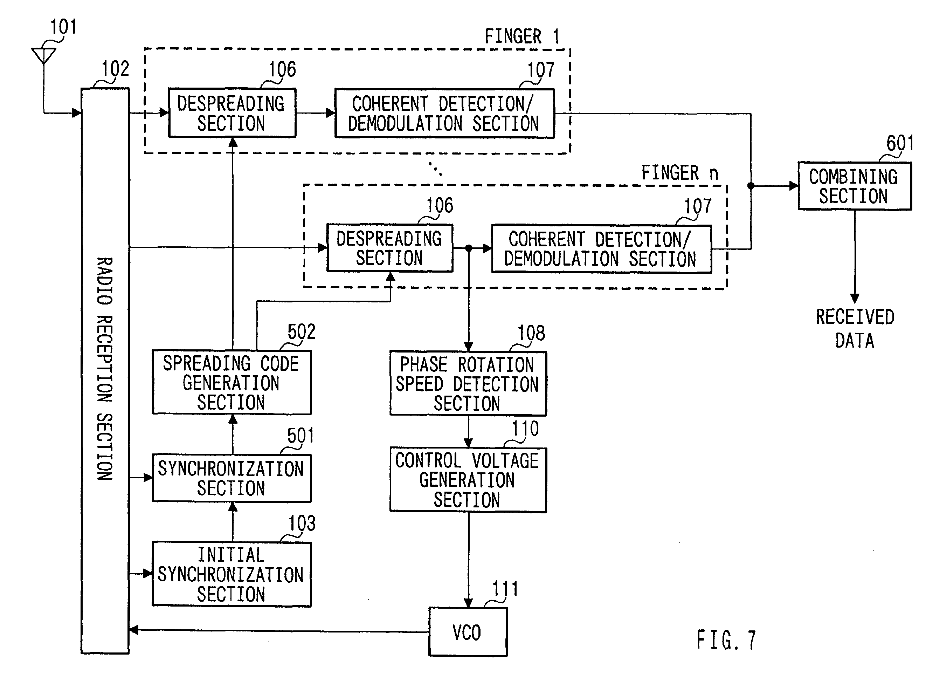

Furthermore, the CDMA radio reception apparatus according to this embodiment can also have a configuration using despreading section 106 of one of a plurality of fingers as an AFC despreading section as shown in FIG. 7. The CDMA radio reception apparatus shown in FIG.7 adopts a finger configuration of finger 1 to n made up of a despreading section and coherent detection/demodulation section and combining section 601 obtains received data by combining signals from coherent detection/demodulation sections 107 of a plurality of fingers at a maximum ratio. In the case of the CDMA radio reception apparatus having such a configuration, the despreading sections are provided for finger 1 to n beforehand and therefore it is not necessary to newly provide an AFC despreading section and it is possible to implement the CDMA radio reception apparatus of this embodiment using despreading section 106 of one of fingers 1 to n as the AFC despreading section.

Thus, the CDMA radio reception apparatus of this embodiment performs AFC using the signal with a path with the highest reception level among those subjected to cell search so far, and therefore AFC will be no longer performed using the signal with a path with a low reception level. Thus, the CDMA radio reception apparatus of this embodiment can prevent the carrier frequency error from increasing during a cell search and can improve the accuracy of cell search.

Furthermore, it is also possible to combine Embodiments 1 to 3 above with Embodiment 4 above as appropriate.

As described above, the present invention can prevent the carrier frequency error from increasing for a period during which no known reference signal is sent from the other end of communication or during a cell search when power is turned on.

This application is based on the Japanese Patent Application No.HEI 11-191467 filed on July 6, 1999, entire content of which is expressly incorporated by reference herein.

### Industrial Applicability

The present invention is applicable to a communication terminal apparatus such as a mobile station apparatus used in a mobile communication system.

## Claims

1. A radio reception apparatus comprising:
a detector that detects a phase rotation speed of a known reference signal containing an in-phase component and quadrature component;
a measurer that measures a value indicative of the reception quality of the known reference signal;
a control voltage generator that updates a control voltage according to the phase rotation speed and the reception quality; and
a carrier generator that generates a carrier with a frequency according to the control voltage.

2. The radio reception apparatus according to claim 1, the control voltage generator comprising:
a control amount calculator that calculates the amount of variation of the control voltage according to the polarity of phase rotation speed and the absolute value of the phase rotation speed; and
a coefficient calculator that calculates a coefficient according to the value indicative of the reception quality, wherein the amount of variation of the control voltage is multiplied by the coefficient and thereby the control voltage is updated by decreasing the amount of variation of the control voltage as the reception quality deteriorates.

3. The radio reception apparatus according to claim 1, the control voltage generator comprising:
a control amount calculator that calculates the amount of variation of the control voltage according to the polarity of phase rotation speed and the absolute value of the phase rotation speed; and
a determinator that determines that the reception quality deteriorates based on the value indicative of the reception quality, wherein when the reception quality deteriorates, the control voltage is not updated.

4. A radio reception apparatus comprising:
a detector that detects a phase rotation speed of a known reference signal containing an in-phase component and quadrature component;
a counter that determines the signal point location in the quadrant of the known reference signal on a rectangular coordinate plane and counts the number of errors that exist in quadrants other than the quadrant in which the signal point should originally be located;
a control voltage generator that updates a control voltage according to the phase rotation speed and the error count; and
a carrier generator that generates a carrier with a frequency according to the control voltage.

5. The radio reception apparatus according to claim 4, the control voltage generator comprising:
a control amount calculator that calculates the amount of variation of the control voltage according to the polarity of phase rotation speed and the absolute value of the phase rotation speed; and
a coefficient calculator that calculates a coefficient according to the error count, wherein the amount of variation of the control voltage is multiplied by the coefficient and thereby the control voltage is updated by decreasing the amount of variation of the control voltage as the error count increases.

6. The radio reception apparatus according to claim 4, the control voltage generator comprising:
a control amount calculator that calculates the amount of variation of the control voltage according to the polarity of phase rotation speed and the absolute value of the phase rotation speed; and
a determinator that determines that the reception quality deteriorates based on the error count, wherein when the reception quality deteriorates, the control voltage is not updated.

7. A radio reception apparatus comprising:
a plurality of despreaders that despreads a received signal;
a synchronizer that specifies a spreading code of a received signal with the highest reception level among the spreading codes identified during a cell search for one of the plurality of despreaders during the cell search;
a detector that detects a phase rotation speed of a known reference signal containing an in-phase component and quadrature component in the received signal despread by the one despreader;
a control voltage generator that updates a control voltage according to the phase rotation speed; and
a carrier generator that generates a carrier with a frequency according to the control voltage.

8. A communication terminal apparatus including a radio reception apparatus, the radio reception apparatus comprising:
a detector that detects a phase rotation speed of a known reference signal containing an in-phase component and quadrature component;
a measurer that measures a value indicative of the reception quality of the known reference signal;
a control voltage generator that updates a control voltage according to the phase rotation speed and the reception quality; and
a carrier generator that generates a carrier with a frequency according to the control voltage.

9. A communication terminal apparatus including a radio reception apparatus, the radio reception apparatus comprising:
a detector that detects a phase rotation speed of a known reference signal containing an in-phase component and quadrature component;
a counter that determines the signal point location in the quadrant of the known reference signal on a rectangular coordinate plane and counts the number of errors that exist in quadrants other than the quadrant in which the signal point should originally be located;
a control voltage generator that updates a control voltage according to the phase rotation speed and the error count; and
a carrier generator that generates a carrier with a frequency according to the control voltage.

10. A communication terminal apparatus including a radio reception apparatus, the radio reception apparatus comprising:
a plurality of despreaders that despreads a received signal;
a synchronizer that specifies a spreading code of a received signal with the highest reception level among the spreading codes identified during a cell search for one of the plurality of despreaders during the cell search;
a detector that detects a phase rotation speed of a known reference signal containing an in-phase component and quadrature component in the received signal despread by the one despreader;
a control voltage generator that updates a control voltage according to the phase rotation speed; and
a carrier generator that generates a carrier with a frequency according to the control voltage.

11. A radio reception method comprising:
a detecting step of detecting a phase rotation speed of a known reference signal containing an in-phase component and quadrature component;
a measuring step of measuring a value indicative of the reception quality of the known reference signal;
a control voltage generating step of updating a control voltage according to the phase rotation speed and the reception quality; and
a carrier generating step of generating a carrier with a frequency according to the control voltage.

12. A radio reception method comprising:
a detecting step of detecting a phase rotation speed of a known reference signal containing an in-phase component and quadrature component;
a counting step of determining the signal point location in the quadrant of the known reference signal on a rectangular coordinate plane and counting the number of errors that exist in quadrants other than the quadrant in which the signal point should originally be located;
a control voltage generating step of updating a control voltage according to the phase rotation speed and the error count; and
a carrier generating step of generating a carrier with a frequency according to the control voltage.

13. A radio reception method comprising:
a plurality of despreading steps of despreading a received signal;
a synchronizing step of specifying a spreading code of a received signal with the highest reception level among the spreading codes identified during a cell search for one of the plurality of despreading steps during the cell search;
a detecting step of detecting a phase rotation speed of a known reference signal containing an in-phase component and quadrature component in the received signal despread by the one despreading step;
a control voltage generating step of updating a control voltage according to the phase rotation speed; and
a carrier generating step of generating a carrier with a frequency according to the control voltage.
